# EUROPEAN PATENT SPECIFICATION

(11) **EP 0 405 501 B1**
(45) Date of publication and mention of the grant of the patent: **14.05.2003**
(21) Application number: 90112253.1
(22) Date of filing: 27.06.1990
(51) Int. Cl.: H01L 23/485

(54) **Semiconductor device**
Halbleiteranordnung
Dispositif à semi-conducteurs

(30) Priority: 27.06.1989 JP 16453389
(43) Date of publication of application: 02.01.1991
(73) Proprietor: KABUSHIKI KAISHA TOSHIBA, Kawasaki-shi, Kanagawa-ken 210-8572 (JP)
(72) Inventor: Ono, Tadaaki, c/o Intellectual Property Division, Minato-ku, Tokyo 105 (JP)
(74) Representative: Lehn, Werner, Dipl.-Ing.

(56) References cited:
- EP-A- 0 271 110
- EP-A- 0 328 262
- GB-A- 2 092 376

## Description

The present invention relates to an improvement in electrodes of a semiconductor device in which a copper type wire is used as a bonding wire.

Generally, in a high-frequency semiconductor device, an integrated circuit and the like, an electrode is formed of aluminum. The aluminum allows a bonding pad to be formed on an oxide film on a silicon substrate.

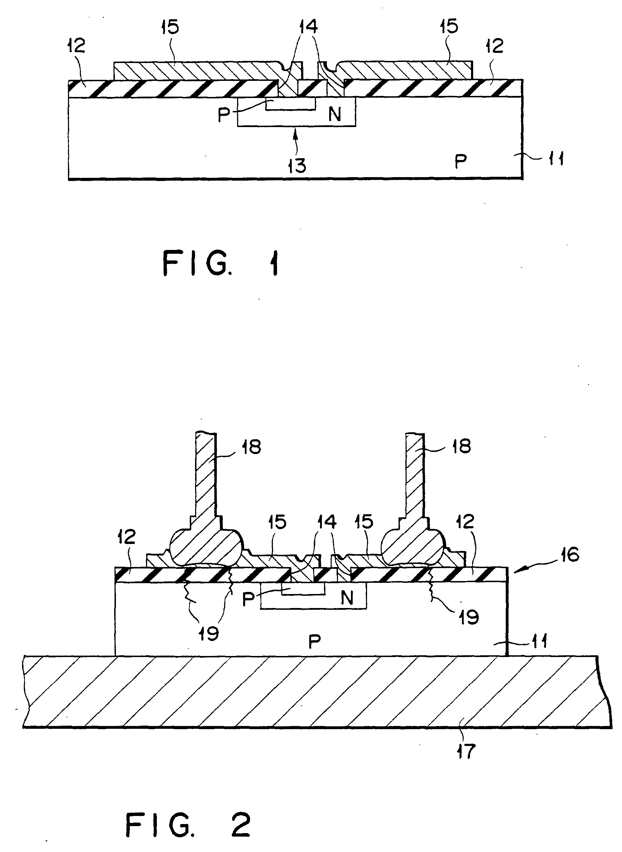

Fig. 1 is a cross-sectional view showing a conventional semiconductor device.

In Fig. 1, element 13 having a PN junction, such as a transistor, is formed in the surface region of silicon substrate 11. Oxide film 12 is formed on silicon substrate 11 and has contact hole 14 for extracting an electrode. Aluminum electrode 15 is thus extracted through contact hole 14 and allows a bonding pad to be formed on oxide film 12.

The above-described configuration of the conventional semiconductor device has a drawback wherein a stress locally concentrates directly under the bonding pad.

As illustrated in Fig. 2, semiconductor chip 16 including the above-described configuration of the conventional semiconductor device is mounted on lead frame 17. Aluminum electrode 15 is thus connected to an external lead by copper type wire 18 made of copper, copper alloy or the like. Since the wire is stiff enough to be used as a bonding wire, aluminum electrode 15 is bent to be connected to the external lead. In the conventional semiconductor device, semiconductor chip 16 is greatly damaged and crack 19 is easy to occur in oxide film 12 directly under the bonding pad or even in silicon substrate 11 under oxide film 12.

If crack 19 occurs in oxide film 12, an insulation state cannot be maintained, and a leak or a short circuit is caused between electrodes.

GB-2 092 376 discloses a semiconductor device in which a silicon nitride layer is provided on top of a PSG layer to thereby protect the PSG layer from moisture which enters through a bonding aperture. The silicon nitride layer and PSG layer are both provided under the bonding aperture and between a metalization layer and a silicon dioxide layer. EP-A-0 271 110 discloses a semiconductor device in which a copper or copper alloy bonding wire is bonded to an electrode pad, where the electrode pad is formed of a first metal that is ohmically in contact with a semiconductor element, where a second metal layer hard enough to not be deformed at the wire bonding step is provided above the first metal and a third metal layer for bonding the copper wire is provided above the second layer, where this third metal layer is soft enough to be deformed by the copper bonding wire. Document EP-A-0 328 262 which was published after the priority date of the present application, discloses a bonding pad under which sandwiched silicon oxide and silicon nitride layers are provided for protecting the components beneath the bonding pad. Patent Abstracts of Japan, Vol. 1, No. 139 (E-064), 15.11.1977 discloses a semiconductor device in which a silicon carbide film is used for the purpose of moisture and thermal resistance and is combined with a film of PSG and silicon nitride. US-4,507,673 discloses a semiconductor

A semiconductor device according to still another aspect of the present invention comprises:
a semiconductor substrate on which a semiconductor element is formed;
a first insulation film having a contact hole in a predetermined region thereof;
a metal film connected to the semiconductor element through the contact hole, for forming a bonding pad on the first insulation film; and
a second insulation film which is formed between the first insulation film and the bonding pad and which is stiffer than the first insulation film.

This invention can be more fully understood from the following detailed description when taken in conjunction with the accompanying drawings, in which:
Fig. 1 is a cross-sectional view showing a conventional semiconductor device;
Fig. 2 is a cross-sectional view showing a semiconductor chip including the conventional semiconductor device shown in Fig. 1, in which a copper type wire is used as a bonding wire;
Fig. 3 is a cross-sectional view showing a semiconductor device according to an embodiment of the present invention; and
Fig. 4 is a cross-sectional view showing a semiconductor chip including the semiconductor device shown in Fig. 3, in which a copper type wire is used as a bonding wire.

A semiconductor device according to an embodiment of the present invention will be described in detail with reference to the accompanying drawings. The elements common to all the drawings are denoted by the same reference numerals to avoid repeating the descriptions of the same elements.

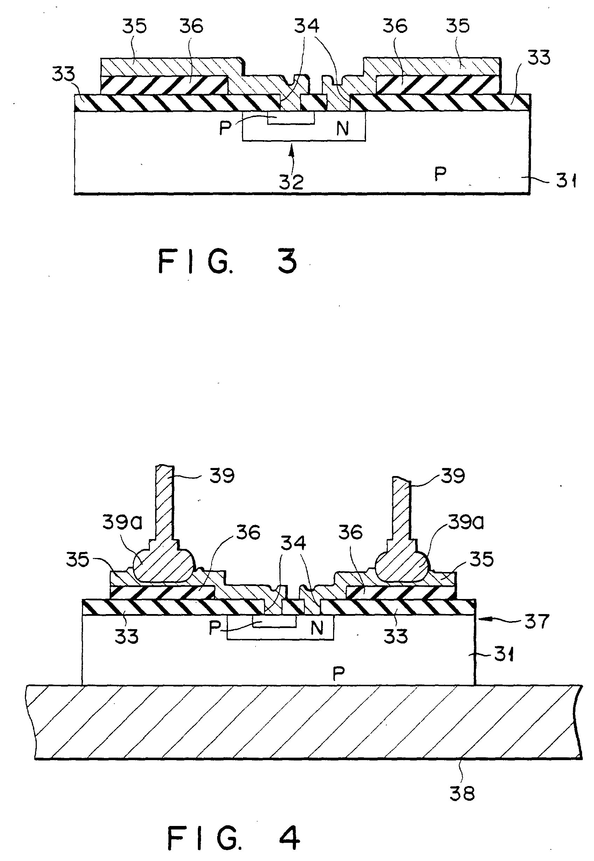

Fig. 3 is a cross-sectional view showing a semiconductor device according to an embodiment of the present invention.

In Fig. 3, element 32 having a PN junction is formed in the surface region of silicon substrate 31. A silicon oxide film (SiO₂ film) is formed on silicon substrate 31 so as to form a first insulating film (33). Contact hole 34 for extracting an electrode is formed in oxide film 33. Aluminum electrodes 35 is thus extracted through contact hole 34 and allows a bonding pad to be formed. A silicon carbide film as a film forming a second insulating film (36) which is stiffer than oxide film 33, is formed between the bonding pad and oxide film 33.

Fig. 4 is a cross-sectional view showing a semiconductor chip including the semiconductor device shown in Fig. 3, in which a copper type wire is used as a bonding wire .

In Fig. 4, semiconductor chip 37 on which the semiconductor device shown in Fig. 3 is mounted on lead frame 38. Lead frame 38 is then heated at 200 to 450°C and copper type wire 39 is bonded to the bonding pad of semiconductor chip 37 by thermocompression bonding or vibration (ultrasound).

When copper type wire 39 is bonded to the bonding pad, ball 39a of wire 39 and aluminum electrode 35 serving as a bonding pad are deformed, which causes a shock in a lower portion of the bonding pad. Since the silicon carbide film 36, which is stiffer than oxide film 33, is formed directly under the bonding pad to which wire 39 is bonded, a stress can be prevented from locally concentrating directly under the bonding pad and thus a shock can be reduced.

Conventionally, 5 to 30 percent of manufactured semiconductor devices had defects of leakage and defects in withstand voltage as initial characteristics. In the present invention, the rate of semiconductor devices having such defects can be decreased below 0.01 %. It is turned out from a high-temperature shelf test and a heat cycle test that the semiconductor device of the present invention has ten times as long duration of time as the conventional device has.

A method of manufacturing a semiconductor device according to the present invention will be described with reference to Fig. 3.

First, oxide film 33 is formed on silicon substrate 31 in which element 32 is formed, and contact hole 34 is formed in a predetermined region of oxide film 33. Silicon carbide film 36 is then deposited on oxide film 33 by the LPCVD method and is patterned by the PEP (photo etching process). After that, aluminum is deposited on silicon carbide film 36 and then patterned to form aluminum electrode 35 having a bonding pad.

To increase the step coverage of aluminum electrode 35, it is effective to form an oxide film on silicon carbide film 36 by the CVD method.

It is preferable that the thickness of silicon carbide film 36 formed directly under the bonding pad is within a range capable of obtaining an effect of reducing a shock caused by bonding of the bonding wire.

It is desirable that the thickness of the nitride film formed by at least 50 nm (500 Å) and it is the most effective that the thickness ranges from 1000 to 3000 Å.

In the above embodiment, the silicon carbide film 36 is used as a compound for reducing a shock formed directly under the bonding pad. Even if the silicon carbide film is used in combination with a nitrogen compound the same effect can be obtained.

It is needless to say that the present invention can be applied to all semiconductor elements as well as transistors, diodes and IC elements.

Reference signs in the claims are intended for better understanding and shall not limit the scope.

## Claims

1. A semiconductor device comprising:
a semiconductor substrate (31);
a first insulation film (33) made of silicon oxide formed on said semiconductor substrate;
a metal film (35) made of aluminum having a bonding pad portion formed above said first insulation film;
a second insulation film (36) formed between said first insulation film and bonding pad portion and being in contact with said first insulation film and said bonding pad portion, and
a bonding wire (39) connected to said bonding pad portion
**characterized in that**
said second insulation film is formed directly under said bonding pad portion, and is stiffere than said first insulation film for preventing stress from locally concentrating under said bonding pad portion,
said second insulation film is made of silicon carbide; and said bonding wire (39) is made of one of copper and an alloy containing copper.

2. Semiconductor device according to claim 1,
**characterized in that**
said second insulation film (36) has a thickness of 50 nm (500 Å) or more.

3. Semiconductor device in accordance with any of claims 1 and 2;
**characterized by**
a semiconductor element formed in said substrate (31);
said first insulation film having a contact hole in a predetermined region thereof; and
said metal film (35) being connected to said semiconductor element through said contact hole.

## Patentansprüche

1. Halbleitereinrichtung, umfassend:
ein Halbleitersubstrat (31);
eine erste Isolierschicht (33) aus Siliziumoxid, ausgebildet auf dem Halbleitersubstrat;
eine Metallschicht (35) aus Aluminium mit einem Kontaktfleckabschnitt, ausgebildet auf der ersten Isolierschicht;
eine zweite Isolierschicht (36), ausgebildet zwischen der ersten Isolierschicht und dem Kontaktfleckabschnitt und in Kontakt mit der ersten Isolierschicht und dem Kontaktfleckabschnitt, und
einen Verbindungsdraht (39), verbunden mit dem Kontaktfleckabschnitt,
***dadurch gekennzeichnet, dass***
die zweite Isolierschicht unmittelbar unter dem Kontaktfleckabschnitt ausgebildet ist und steifer ist als die erste Isolierschicht um lokal konzentrierte Beanspruchung unter dem Kontaktfleckabschnitt zu verhüten,
die zweite Isolierschicht aus Siliziumkarbid gebildet ist; und
der Verbindungsdraht (39) aus Kupfer oder einer Kupfer enthaltenden Legierung besteht.

2. Halbleitereinrichtung nach Anspruch 1,
***dadurch gekennzeichnet, dass***
die zweite Isolierschicht (36) eine Dicke von 50 nm (500 Å) oder mehr hat.

3. Halbleitereinrichtung nach einem der Ansprüche 1 und 2;
***gekennzeichnet durch***
ein in dem Substrat (31) ausgebildetes Halbleiterelement;
wobei die erste Isolierschicht ein Kontaktloch in einer vorbestimmten Region davon hat; und
die Metallschicht (35) mit dem Halbleiterelement **durch** das Kontaktloch verbunden ist.

## Revendications

1. Dispositif semi-conducteur comprenant :
un substrat semi-conducteur (31) ;
un premier film d'isolation (33) fait d'oxyde de silicium formé sur ledit substrat semi-conducteur ;
un film métallique (35) fait d'aluminium ayant une partie de plage de connexion formée au-dessus dudit premier film d'isolation ;
un second film d'isolation (36) formé entre ledit premier film d'isolation et une partie de plage de connexion et étant en contact avec ledit premier film d'isolation et ladite partie de plage de connexion, et
un fil de câblage (39) raccordé à ladite partie de plage de connexion
**caractérisé en ce que**
ledit second film d'isolation est formé directement sous ladite partie de plage de connexion, et est plus rigide que ledit premier film d'isolation pour empêcher la contrainte de se concentrer localement sous ladite partie de plage de connexion,
ledit second film d'isolation est fait de carbure de silicium ; et
ledit fil de câblage (39) est fait soit de cuivre soit d'un alliage contenant du cuivre.

2. Dispositif semi-conducteur selon la revendication 1 **caractérisé en ce que** ledit second film d'isolation (36) possède une épaisseur de 50 nm (500 Å) ou plus.

3. Dispositif semi-conducteur selon l'une quelconque des revendications 1 et 2 ;
**caractérisé par**
un élément semi-conducteur formé dans ledit substrat (31) ;
ledit premier film d'isolation ayant un trou de contact dans une zone prédéterminée de celui-ci ; et
ledit film métallique (35) étant raccordé audit élément semi-conducteur via ledit trou de contact.
